(19) Europäisches Patentamt
European Patent Office
Office européen des brevets

(11) **EP 2 549 612 A2**

(12) **EUROPÄISCHE PATENTANMELDUNG**

(43) Veröffentlichungstag:
 **23.01.2013 Patentblatt 2013/04**

(51) Int Cl.:
 *H02H 7/26* *(2006.01)*

(21) Anmeldenummer: **12173988.2**

(22) Anmeldetag: **28.06.2012**

(84) Benannte Vertragsstaaten:
 **AL AT BE BG CH CY CZ DE DK EE ES FI FR GB GR HR HU IE IS IT LI LT LU LV MC MK MT NL NO PL PT RO RS SE SI SK SM TR**
 Benannte Erstreckungsstaaten:
 **BA ME**

(30) Priorität: **22.07.2011 DE 102011079652**

(71) Anmelder: **SIEMENS AKTIENGESELLSCHAFT**
 **80333 München (DE)**

(72) Erfinder:
 • **Kiendl, Thomas**
  **92533 Wernberg-Köblitz (DE)**
 • **Nerl, Cornelia**
  **92421 Schwandorf (DE)**
 • **Götz, Josef**
  **92272 Freudenberg - Aschach (DE)**

(54) **Verfahren zum Sperren eines Schalters**

(57) Die Erfindung betrifft ein Verfahren zum Sperren eines von einer Stromeinspeisung (3) aus gesehen vorgeordneten Schalters (2), dem ein Schalter (2, 2a) nachgeordnet ist, wobei die Schaltkontakte der Schalter (2, 2a) bei Überschreitung eines Stromschwellwerts selbsttätig öffnen, insbesondere bei einem Kurzschlussstrom, und wobei die Schalter (2, 2a) signaltechnisch miteinander verbunden sind, bei dem der nachgeordnete Schalter (2, 2a) jeweils ein Sperrsignal über die Verbindung an den vorgeordneten Schalter (2) sendet, wobei der vorgeordnete Schalter (2) zumindest aufgrund des gesendeten Sperrsignals geschlossen bleibt. Um eine schnelle Erfassung eines Kurzschlusses im elektrischen Netz mit geringem Aufwand zu erzielen, wird vorgeschlagen, dass der Strom abgetastet, digitalisiert und für eine fest vorgegebene Anzahl unmittelbar aufeinander folgender Stromwerte mittels einer Wavelet-Transformation jeweils Wavelet-Koeffizienten mindestens eines Zerlegungslevels berechnet und mit einem Wavelet-Schwellwert verglichen werden sowie dass das Sperrsignal an den vorgeordneten Schalter (2) gesendet wird, wenn jeweils eine vorgegebene Anzahl unmittelbar aufeinander folgender Waveletkoeffizienten den zugehörigen Wavelet-Schwellwert überschreitet.

EP 2 549 612 A2

**Beschreibung**

Die Erfindung betrifft ein Verfahren zum Sperren eines von der Stromeinspeisung aus gesehen vorgeordneten Schalters gemäß dem Oberbegriff des Anspruchs 1.

Stromverteilungssysteme mit einer Stromeinspeisung, an die eine Schalteranordnung angeschlossen ist, sind bekannt. Dabei wird der Strom über die Schalter auf die einzelnen Anlagenzweige verteilt. Bei den Schaltern handelt es sich insbesondere um Leistungsschalter für den Niederspannungsbereich, die jeweils für einen Nennstrom ausgelegt sind und den durch den Schalter fließenden Strom im Fehlerfall unterbrechen. Dabei soll jeweils nur der Anlagenzweig abgeschaltet werden, der von dem Fehler betroffen ist, d.h. es soll nur der Schalter öffnen, der dem Fehler am nächsten liegt. Dieses Verhalten wird selektives Abschaltverhalten genannt. Die Schalter sind in der Schalteranordnung einer Schaltanlage gestaffelt angeordnet, wobei mindestens zwei Schalter in Reihe geschaltet sind. Zumindest jeder von der Einspeisung aus gesehen vorgeordnete Schalter weist eine Erfassungseinrichtung und eine Auslöseeinheit auf, wobei die Erfassungseinrichtung mit Hilfe von Wandlern sowohl den durch den Schalter fließenden Strom und gegebenenfalls auch die an dem zugehörigen Anlagenzweig abfallende Spannung erfasst. Zur Erfassung sowohl eines Überlast- als auch eines Kurzschlussstroms dient eine elektronische Auslöseeinheit, die den mittels Wandler erfassten Strom analog aufbereitet und anschließend digitalisiert. Zur Auslöseeinheit gehört ein Mikrocontroller, der die digitalisierten Stromwerte (Abtastwerte) über entsprechende Rechenalgorithmen auswertet und bei erkanntem Überlast- und Kurzschlussstrom z.B. einen Magnetaktor aktiviert und den Schalter ausschaltet.

Bei Schaltern mit strombegrenzenden Eigenschaften öffnen sich die Kontakte des vom Strom durchflossenen Pols bei Überschreitung eines bestimmten Stromwerts infolge der auf den jeweiligen Kontaktarm wirkenden Stromkräfte kurzzeitig. Dabei kommt es zu einem Lichtbogen, der einen Verschleiß der Kontakte bewirkt, wodurch wiederum die Lebensdauer des Schalters reduziert wird. Aus diesem Grunde ist es notwendig, einen Kurzschluss so schnell wie möglich zu erfassen und abzuschalten.

Die Zonenselektivität, auch als zonenselektive Verriegelung bezeichnet, ermöglicht die Erzielung eines selektiven Verhaltens von Leistungsschaltern zueinander. Dabei ist der nachgeordnete Schalter signaltechnisch mit dem unmittelbar vorgeordneten Schalter verbunden. Über diese Verbindung sendet der nachgeordnete Schalter jeweils ein Sperrsignal an den vorgeordneten Schalter, bevor und während er den Strom unterbricht, um dies dem vorgeordneten Schalter anzuzeigen. Aufgrund des gesendeten Sperrsignals bleibt der vorgeordnete Schalter zumindest für eine vorgegebene Verzögerungszeit geschlossen. Der nachgeordnete Leistungsschalter führt eine Auslösung durch, falls er innerhalb einer festgelegten Zeitdauer kein Sperrsignal von einem weiteren nachgeordneten Schalter empfängt.

Zur schnellen Erkennung eines Kurzschlusses im elektrischen Netz anhand des Stromverlaufs ist es bekannt, die Stromwerte einer Wavelet-Transformation zu unterziehen und die Wavelet-Koeffizienten von mehreren Zerlegungsleveln zu berechnen und miteinander zu vergleichen. Anhand des Vergleichs wird dann entschieden, ob ein Kurzschluss vorliegt oder nicht.

Die Aufgabe der Erfindung ist es, eine schnelle Erkennung eines Kurzschlusses mit geringerem Aufwand in Kombination mit einer zonenselektiven Verriegelung vorzuschlagen.

Die Aufgabe wird bezogen auf das Verfahren durch die Merkmale des Anspruchs 1 gelöst; der Unteranspruch stellt eine vorteilhafte Ausgestaltung dar.

Die Lösung sieht vor, dass der Strom mit einer fest vorgegebenen Abtastfrequenz abgetastet, digitalisiert und für eine fest vorgegebene Anzahl unmittelbar aufeinander folgender digitalisierter Stromwerte mittels einer Wavelet-Transformation jeweils unmittelbar aufeinander folgende Wavelet-Koeffizienten mindestens eines Zerlegungslevels berechnet und mit einem vorgegebenen vom Zerlegungslevel abhängigen Wavelet-Schwellwert verglichen werden sowie dass ein Kurzschluss im elektrischen Netz erkannt und das Sperrsignal an den vorgeordneten Schalter gesendet wird, wenn jeweils eine vorgegebene Anzahl unmittelbar aufeinander folgender Wavelet-Koeffizienten ein und desselben Zerlegungslevels den zugehörigen Wavelet-Schwellwert überschreiten. Je nachdem, welches Mother-Wavelet verwendet wird, lassen sich unterschiedliche Charakteristiken des Stromverlaufs über die Betrachtung der Wavelet-Koeffizienten identifizieren.

Die Erfindung wird nachfolgend anhand eines Stromverteilungssystems in Form einer Schaltanlage 1 beispielhaft näher beschrieben, wobei die einzige Figur eine schematische Darstellung der Schaltanlage 1 mit Schaltern 2, 2a zeigt.

In der Schaltanlage 1 sind mehrere Schalter 2, 2a gestaffelt angeordnet, wobei sich der Strom von einer Einspeisung 3 aus über die Schalter 2, 2a auf die einzelnen Anlagenzweige (nicht weiter gezeigt) verteilt. Bei den Schaltern 2, 2a handelt es sich um Leistungsschalter für den Niederspannungsbereich, die jeweils für einen Nennstrom ausgelegt sind und über eine elektronische Auslöseeinheit mit Überlast- und Kurzschlussschutz verfügen. Durch jeden der Schalter 2, 2a ist für jede Phase ein Leiter geführt. Bei geschlossenem Schalter 2, 2a liegen die Schaltkontakte jeder Phase aneinander an. Zum Öffnen eines Schalters 2, 2a werden dessen Schaltkontakte durch einen Schaltmechanismus voneinander getrennt.

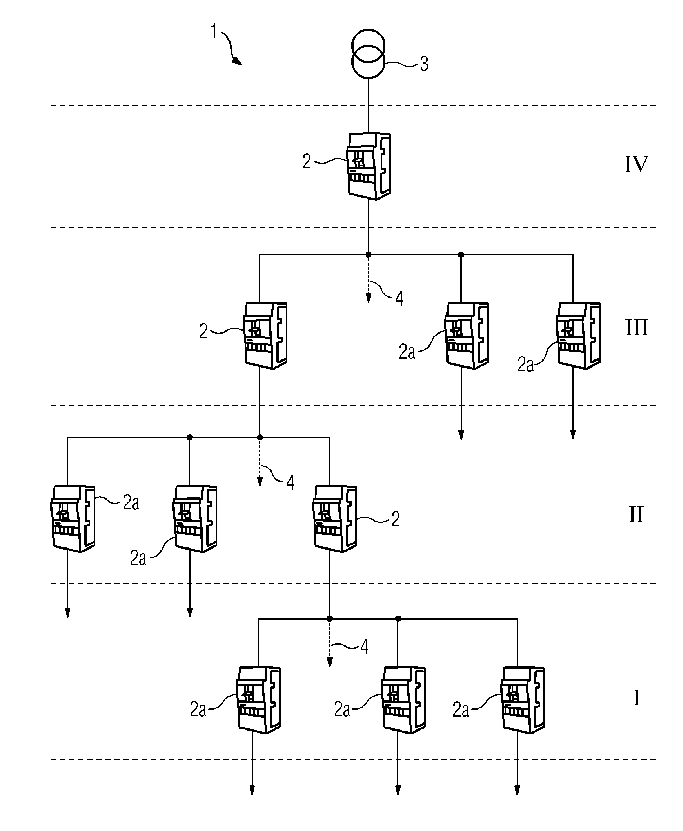

Der Schalter 2 unmittelbar hinter der Einspeisung 3 bildet hier die Staffelebene IV der Schaltanlage 1, also die IV. oder höchste Staffelebene. Die drei Schalter 2, 2a unter der Staffelebene IV bilden die Staffelebene III, die drei Schalter 2, 2a unter der Staffelebene III die Staffelebene II und die drei Schalter 2a unter der Staffelebene II die Staffelebene I. Alle Schalter, die Endabzweigschalter sind, sind in Fig. 1 mit der Bezugsziffer 2a gekennzeichnet. Beispielsweise sind die beiden in der Figur rechts dargestellten Schalter 2a der Staffelebene III Endabzweigschalter, an die je ein Anlagenzweig als Endabzweig und kein weiterer Schalter 2 nachgeordnet ist. Somit ist in Fig. 1 also jedem Schalter 2a mindestens ein Schalter 2 vorgeordnet und kein Schalter 2, 2a nachgeordnet. Einem Schalter 2 können Schalter 2 vorgeordnet und Schalter 2, 2a nachgeordnet sein. Die Pfeile 4 zeigen jeweils in Richtung Anlage bzw. in Richtung Anlagenzweig. Von der Einspeisung 3 aus gesehen fließt der Strom durch den Schalter 2 der Staffelebene IV und dann durch die diesem Schalter 2 nachgeordneten Schalter 2, 2a der Staffelebene III. Der in Fig. 1 links dargestellte Schalter 2 der Staffelebene III ist mit den drei Schaltern 2, 2a der Staffelebene II verbunden, von denen die beiden in Fig. 1 links dargestellten Schalter 2a der Staffelebene II ebenfalls Endabzweigschalter sind. Der rechts dargestellte Schalter 2 der Staffelebene II ist wiederum mit den drei Schaltern 2a der Staffelebene I verbunden, die alle drei Endabzweigschalter sind.

Der Strom, der durch einen Schalter 2a der Staffelebene I fließt, fließt auch durch den rechten Schalter 2 der Staffelebene II, und der Strom, welcher durch den linken Schalter 2 der Staffelebene III, fließt auch durch den Schalter 2 der Staffelebene IV. Diese Schalter 2 sind quasi in Reihe geschaltet. Ein Kurzschlussstrom in einem Anlagenzweig, der an einen der Schalter 2a der Staffelebene I angeschlossen ist, fließt also durch die drei in Reihe geschalteten Schalter 2.

Von der Einspeisung 3 aus gesehen ist der Schalter 2 der Staffelebene IV den Schaltern 2, 2a der Staffelebene III vorgeordnet, umgekehrt sind die Schalter 2, 2a der Staffelebene III dem Schalter 2 der Staffelebene IV nachgeordnet.

Jeder Schalter 2, 2a weist eine elektronische Auslöseeinheit mit einer Erfassungseinrichtung für den Strom auf, welcher durch den (zugehörigen) Schalter 2, 2a fließt. Der Strom wird mit einer fest vorgegebenen Abtastfrequenz 1/T (T ist das zeitliche Abtastintervall) abgetastet und anschließend digitalisiert.

Weiter weist die elektronische Auslöseeinheit jedes Schalters 2, 2a einen Mikrocontroller auf.

Die Schalter 2, 2a sind Strom begrenzend, d.h. sie öffnen ihre Kontakte bei Überschreitung eines bestimmten Stromwerts kurzzeitig aufgrund der auf ihre Kontaktarme wirkenden Stromkräfte. Dabei entsteht jeweils ein Lichtbogen.

Der Mikrocontroller jeder elektronischen Auslöseeinheit ist mit einem Rechenalgorithmus ausgestattet, der für eine fest vorgegebene Anzahl unmittelbar aufeinander folgender digitalisierter Stromwerte mittels einer Wavelet-Transformation jeweils die Wavelet-Koeffizienten von mindestens einem Zerlegungslevel berechnet.

Als Mother-Wavelet wird hier das Haar-Wavelet verwendet; es käme aber auch das Daubechies-Wavelet oder ein anderes geeignetes Mother-Wavelet in Frage.

Vom Haar-Wavelet werden jeweils die Wavelet-Koeffizienten beispielsweise von zwei Zerlegungsleveln (Zerlegungslevel 1 und 2) berechnet, d.h. die Wavelet-Koeffizienten d1k von Zerlegungslevel 1:

$$d_{1k} = \left(i_k - i_{k-1}\right)/\sqrt{2}$$

und

die Wavelet-Koeffizienten d2k von Zerlegungslevel 2:

$$d_{2k} = \left(\left(i_k + i_{k-1}\right) - \left(i_{k-2} + i_{k-3}\right)\right)/2$$

Dabei stellt ik bzw. ik-1 den Strom-Abtastwert zum Zeitpunkt k*T bzw. (k-1)*T dar, wobei T das zeitliche Abtastintervall ist. d1k stellt den Wavelet-Koeffizient des Zerlegungslevels 1 zum Zeitpunkt k*T und d2k den Wavelet-Koeffizient des Zerlegungslevels 2 zum Zeitpunkt k*T dar.

Grundsätzlich könnten auch die Wavelet-Koeffizienten von einem einzigen Zerlegungslevel oder aber von mehr als zwei Zerlegungsleveln berechnet werden. Je nachdem, welches Mother-Wavelet Verwendung findet, lassen sich unterschiedliche Charakteristiken des Stromsignals über die Betrachtung der Wavelet-Koeffizienten identifizieren.

Die Wavelet-Koeffizienten werden mit den Zerlegungsleveln zugeordneten Schwellwerten verglichen, wobei also für jedes Zerlegungslevel ein eigener Schwellwert festgelegt wird.

Um eine gewisse Mittelung zu erreichen, überprüft die Auslöseeinheit fortlaufend, ob hier beispielsweise 10 (allgemein N mit N einer ganzen Zahl größer (gleich) 1) aufeinander folgende Wavelet-Koeffizienten eines Zerlegungslevels dessen Schwellwert überschreiten. Ist dies der Fall, so gilt ein Kurzschluss als erkannt, d.h. für die Auslöseeinheit liegt ein Kurzschluss vor.

Parallel dazu können zusätzlich die Stromwerte mit einem Strom-Schwellwert verglichen werden und die Auslöseeinheit erkennt auch dann einen Kurzschluss (zusätzliche unabhängige Bedingung), wenn eine vorgegebene Anzahl Stromwerte den Strom-Schwellwert überschritten hat.

Jeder nachgeordnete Schalter 2, 2a ist signaltechnisch mit dem unmittelbar vorgeordneten Schalter 2 verbunden. Über die Verbindung sendet der nachgeordnete Schalter 2, 2a zumindest dann jeweils ein Sperrsignal an den vorgeordneten Schalter 2 wenn die Auslöseeinheit anhand der Wavelet-Koeffizienten oder der Stromwerte feststellt, dass ein Kurzschluss vorliegt. Aufgrund des gesendeten Sperrsignals bleibt der vorgeordnete Schalter zumindest für eine vorgegebene Verzögerungszeit geschlossen (blockiert).

Wird ein Kurzschluss erkannt und empfängt der vorgeordnete Schalter 2 innerhalb einer bestimmten (vorgegebenen) Zeitdauer kein Sperrsignal von einem nachgeordneten Schalter 2,2a, so löst die Auslöseeinheit den Schalter 2 über einen Magnetaktor aus.

Durch den Algorithmus in Kombination mit einer signaltechnischen Verbindung der elektronischen Auslöseeinheiten wird also früh erkannt, ob ein nachgeordneter Schalter 2, 2a einen Kurzschlussstrom festgestellt hat und gerade dabei ist, auszulösen. Sollte dieser versagen bzw. zu lange zum Öffnen und damit zum Löschen des Lichtbogens benötigen, so ist es dem vorgeordneten Schalter 2 möglich, dies ebenfalls rasch zu erkennen und im Sinne des Backup-Schutzes anstelle des nachgeordneten Schalters 2, 2a auszulösen.

**Patentansprüche**

1. Verfahren zum Sperren eines von einer Stromeinspeisung (3) aus gesehen vorgeordneten Schalters (2), dem in einer Schalteranordnung (1) zur Stromverteilung mindestens ein Schalter (2, 2a) nachgeordnet ist,

   wobei der durch den nachgeordneten Schalter (2, 2a) fließende Strom auch über den vorgeordneten Schalter (2) fließt,

   wobei der vorgeordnete und der nachgeordnete Schalter (2, 2a) signaltechnisch miteinander verbunden sind,

   bei dem der nachgeordnete Schalter (2, 2a) jeweils ein Sperrsignal über die Verbindung an den vorgeordneten Schalter (2) sendet, um dem vorgeordneten Schalter (2) anzuzeigen, dass er oder ein diesem wiederum nachgeordneter Schalter den Strom unterbrechen werden, wobei der vorgeordnete Schalter (2) aufgrund des gesendeten Sperrsignals zumindest für eine vorgegebene Verzögerungszeit geschlossen bleibt,

   **dadurch gekennzeichnet,**

   **dass** der Strom mit einer fest vorgegebenen Abtastfrequenz abgetastet, digitalisiert und für eine fest vorgegebene Anzahl unmittelbar aufeinander folgender digitalisierter Stromwerte mittels einer Wavelet-Transformation jeweils unmittelbar aufeinander folgende Wavelet-Koeffizienten mindestens eines Zerlegungslevels berechnet und mit einem vorgegebenen vom Zerlegungslevel abhängigen Wavelet-Schwellwert verglichen werden sowie

   **dass** das Sperrsignal an den vorgeordneten Schalter (2) gesendet wird, wenn jeweils eine vorgegebene Anzahl unmittelbar aufeinander folgender Wavelet-Koeffizienten den zugehörigen Wavelet-Schwellwert überschreitet.

2. Verfahren nach Anspruch 1,
   **dadurch gekennzeichnet,**
   **dass** die Wavelet-Transformation mittels des Haar-Wavelets als Mother-Wavelet durchgeführt wird, **dass** jeweils die Wavelet-Koeffizienten (d1k)

$$d_{1k} = \left(i_k - i_{k-1}\right)/\sqrt{2}$$

vom ersten Zerlegungslevel und die Wavelet-Koeffizienten (d2k)

$$d_{2k} = \left(\left(i_k + i_{k-1}\right) - \left(i_{k-2} + i_{k-3}\right)\right)/2$$

vom zweiten Zerlegungslevel berechnet und mit dem Wavelet-Schwellwert verglichen werden, der zum jeweiligen Zerlegungslevel gehört, mit ik bzw. ik-1 gleich dem Strom-Abtastwert zum Zeitpunkt k*T bzw. (k-1)*T sowie d1k bzw. d2k den Wavelet-Koeffizienten des ersten bzw. zweiten Zerlegungslevels zum Zeitpunkt k*T und mit T gleich dem zeitlichen Abtastintervall.